# EUROPEAN PATENT APPLICATION

(11) **EP 4 625 486 A1**
(43) Date of publication of application: **01.10.2025**
(21) Application number: 25154140.5
(22) Date of filing: 27.01.2025
(51) Int. Cl.: H01L 23/00

(54) **THERMAL BONDING SHEET, AND DICING TAPE-EQUIPPED THERMAL BONDING SHEET**

(30) Priority: 19.02.2024 JP 2024023094
(71) Applicant: NITTO DENKO CORPORATION, Ibaraki-shi Osaka 567-8680 (JP)
(72) Inventor: MITA, Ryota, Osaka, 567-8680 (JP); SATO, Mayu, Osaka, 567-8680 (JP)
(74) Representative: Stolmár & Partner Patentanwälte PartG mbB

(57) **Abstract**

Provided is a thermal bonding sheet including: a sinter precursor layer including sinterable particles; and a close adhesion layer superposed on one surface of the sinter precursor layer. The close adhesion layer includes an organic binder and the sinterable particles, a content percentage of the sinterable particles in the close adhesion layer is 5 volume % or more and 40 volume % or less, and a particle size distribution measured for the sinterable particles included in the close adhesion layer has at least two peaks.

## Description

### CROSS-REFERENCE TO RELATED APPLICATION

This application claims priority to Japanese Patent Application No. 2024-023094, the disclosure of which is incorporated herein by reference in its entirety.

### FIELD OF THE INVENTION

The present invention relates to a thermal bonding sheet used in, for example, producing a semiconductor device, and a dicing tape-equipped thermal bonding sheet.

### BACKGROUND OF THE INVENTION

Conventionally known is a thermal bonding sheet used in producing a semiconductor device. The thermal bonding sheet of this type includes a sinter precursor layer including at least sinterable particles. The sinter precursor layer including, for example, an organic binder has pressure-sensitive adhesiveness.

In producing, for example, the semiconductor device, the sinter precursor layer is disposed between one surface of a board and a semiconductor element (e.g., semiconductor chip) and subjected to sintering treatment for use in bonding the board and the semiconductor element to each other. In producing the semiconductor device, for example, steps as shown below are carried out.
(1) A dicing tape formed of a substrate layer and an adhesive layer laminated on each other is prepared, the sinter precursor layer is layered on the adhesive layer of the dicing tape, and a semiconductor wafer is further attached to the sinter precursor layer, followed by dividing the sinter precursor layer and the semiconductor wafer into small pieces.
(2) A small piece of the sinter precursor layer attached to one semiconductor element is separated from the adhesive layer using a jig such as a collet to pick up the semiconductor element with the small piece of the sinter precursor layer attached thereto.
(3) The one semiconductor element with the small piece of the sinter precursor layer adhering thereto is caused to adhere to one surface of a board (i.e., a mounting area of a semiconductor element). That is, the one semiconductor element is temporarily fixed to the board.
(4) Steps (2) and (3) are similarly carried out a plurality of times to temporarily fix a plurality of the semiconductor elements with the small pieces of the sinter precursor layer respectively adhering thereto within the mounting areas of the semiconductor elements. An intermediate product of the semiconductor device is thus obtained.
(5) The intermediate product of the semiconductor device is subjected to sintering treatment in which the intermediate product of the semiconductor device is heated at a temperature at which sinterable particles in the sinter precursor layer can be sintered to each other, to thereby at least partially eliminate the organic binder from the sinter precursor layer while sintering the sinterable particles to each other. Thus, the plurality of semiconductor elements are bonded to the respective mounting areas of the semiconductor elements.

After the above steps are carried out, the sinterable particles included in the sinter precursor layer are sintered to each other to thereby allow the plurality of semiconductor elements to be fixed within the respective mounting areas of the semiconductor elements. That is, the plurality of semiconductor elements are fixed to the respective mounting areas of the semiconductor elements via the respective small pieces of the sinter precursor layer that have been subjected to sintering treatment.

In substitution for steps (1) and (2) above, another possible steps of producing the semiconductor device can include: a step of attaching only a semiconductor wafer onto the adhesive layer of the dicing tape for fixing, followed by dividing only the semiconductor wafer by dicing into a plurality of small semiconductor elements; a step of separating and lifting up one semiconductor element from the adhesive layer using a jig such as a collet, and thereafter pressing the one semiconductor element on the sinter precursor layer of the thermal bonding sheet; a step of cutting out, with such pressing force, a portion of the sinter precursor layer into a small piece having such a size as to correspond to the size of the one semiconductor element and at the same time causing the small piece of the sinter precursor layer to adhere to the semiconductor element; and a step of pulling up the jig such as the collet to pick up the one semiconductor element with the small piece of the sinter precursor layer adhering thereto.

Known as a thermal bonding sheet that can be used in carrying out the method for producing the semiconductor device as above is, for example, a sheet including a sinter precursor layer that turns a rigid sintered layer after sintering treatment and a close adhesion layer to be bonded to, e.g., a semiconductor wafer (for example, JP 2018-037548 A).

Specifically, in the thermal bonding sheet disclosed in JP 2018-037548 A, the sinter precursor layer includes metal microparticles and an organic binder, and the close adhesion layer includes, for example, metal microparticles and an organic binder.

### SUMMARY OF THE INVENTION

### Technical Problem

However, in the close adhesion layer disclosed in JP 2018-037548 A, the organic binder may not necessarily have good dispersibility. Poor dispersibility of the organic binder in the close adhesion layer may cause, for example, the semiconductor wafer and the sinter precursor layer to be separated from each other when the sinter precursor layer and the semiconductor wafer are cut out into small pieces on the dicing tape. More specifically, the separation may occur between two adherends (i.e., sinter precursor layer and semiconductor wafer) respectively attached to both surfaces of the close adhesion layer.

Nevertheless, no sufficient consideration appears to have been made on a thermal bonding sheet including a close adhesion layer with good dispersibility of an organic binder.

It is therefore an object of the present disclosure to provide a thermal bonding sheet including a close adhesion layer with good dispersibility of an organic binder.

### Solution to Problem

In order to solve the above problem, a thermal bonding sheet according to the present disclosure includes: a sinter precursor layer including sinterable particles; and a close adhesion layer superposed on one surface of the sinter precursor layer, in which the close adhesion layer includes an organic binder and sinterable particles, and a content percentage of the sinterable particles in the close adhesion layer is 5 volume % or more and 40 volume % or less, and a particle size distribution measured for the sinterable particles included in the close adhesion layer has at least two peaks.

A dicing tape-equipped thermal bonding sheet according to the present disclosure includes the thermal bonding sheet, and a dicing tape superposed on one surface of the thermal bonding sheet.

### BRIEF DESCRIPTION OF DRAWINGS

Fig. 1A is a schematic cross-sectional view of a thermal bonding sheet of this embodiment obtained by cutting the thermal bonding sheet in its thickness direction.
Fig. 1B is a schematic cross-sectional view of a dicing tape-equipped thermal bonding sheet of this embodiment obtained by cutting the dicing tape-equipped thermal bonding sheet in its thickness direction.
Fig. 2A is a schematic cross-sectional view of the dicing tape-equipped thermal bonding sheet, and a semiconductor wafer superposed thereon.
Fig. 2B is a schematic cross-sectional view showing an example state of cutting the semiconductor wafer and the thermal bonding sheet into small pieces.
Fig. 2C is a schematic cross-sectional view showing a state where a semiconductor chip and a small piece of the thermal bonding sheet are lifted up from the dicing tape by a collet.
Fig. 2D is a schematic cross-sectional view showing a state where a fragile area is formed inside the semiconductor wafer superposed on the dicing tape-equipped thermal bonding sheet.
Fig. 2E is a schematic cross-sectional view showing another example state of cutting the semiconductor wafer and the thermal bonding sheet into small pieces.
Fig. 3A is a schematic cross-sectional view showing a state where the semiconductor chip with the small piece of the thermal bonding sheet attached thereto is temporarily fixed to a board.
Fig. 3B is a schematic cross-sectional view showing a state where another semiconductor chip with the small piece of the thermal bonding sheet attached thereto is temporarily fixed to the board.
Fig. 3C is a schematic cross-sectional view showing an example state where the small piece of the thermal bonding sheet is heated while being pressed.
Fig. 4 includes graphs each showing a specific example of a particle size distribution chart obtained by measuring a particle size distribution of sinterable particles included in a close adhesion layer.
Fig. 5 includes photos each showing an example image of ultrasonic flaw detection of the thermal bonding sheet.

### DETAILED DESCRIPTION OF THE PREFERRED EMBODIMENT

A description will be hereinafter given on one embodiment of a thermal bonding sheet according to the present disclosure with reference to the drawings.

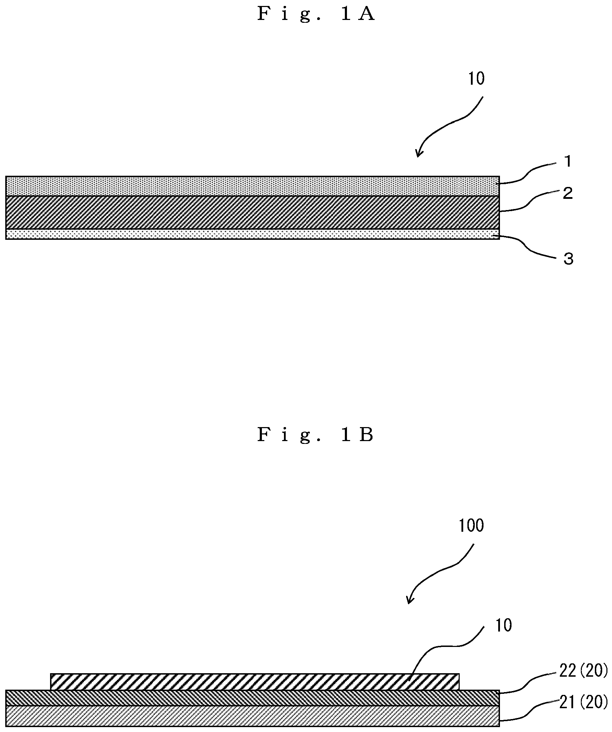

A thermal bonding sheet 10 according to this embodiment includes, as shown in, for example, Fig. 1A, a sinter precursor layer 2 including sinterable particles, and a close adhesion layer 1 including sinterable particles and superposed on one surface of the sinter precursor layer 2. As shown in, for example, Fig. 1A, the thermal bonding sheet 10 according to this embodiment can further include a component transferring prevention layer 3 including at least a resin. Such a component transferring prevention layer 3 is superposed on, for example, an adhesive layer 22 of a dicing tape 20 (see Fig. 1B), which will be described later, for use.

The thermal bonding sheet 10 of this embodiment has, for example, an elongated strip shape. The thermal bonding sheet 10 of this embodiment can be stored in a state wound around into a cylindrical shape.

First, a detailed description will be given on the sinter precursor layer 2, which is the main layer of the thermal bonding sheet 10 of this embodiment.

### [Sinter precursor layer of thermal bonding sheet]

The sintering precursor layer 2 at least includes the sinterable particles, and preferably further includes an organic binder. The sinter precursor layer 2 including the organic binder has pressure-sensitive adhesiveness. Thus, the sinter precursor layer 2 subjected to pressing force can temporarily adhere to an adherend. When the sinter precursor layer 2 is subjected to sintering treatment, the sinterable particles therein are sintered to each other. The sinter precursor layer 2 is, for example, disposed between a board and a semiconductor chip X for sintering treatment to thereby bond the board and the semiconductor chip X to each other. When the sinter precursor layer 2 is subjected to sintering treatment, the organic binder is at least partially eliminated. The organic binder in the sinter precursor layer 2 is preferably substantially absent, more preferably totally absent, after sintering treatment.

Sinterable particles include a conductive metal. Such a conductive metal is a metal having an electrical conductivity of 100 [µS/cm] or more (10⁶ [S/m] or more) as measured according to JIS K 0130 (2008). Examples of the conductive metal include gold, silver, copper, palladium, tin, and nickel. The conductive metal can be an alloy of two or more metals selected from the group consisting of gold, silver, copper, palladium, tin, and nickel. The sinterable particles can include a metal oxide such as silver oxide, copper oxide, palladium oxide, or tin oxide.

In this embodiment, the sinterable particles preferably include at least one selected from the group consisting of silver, copper, silver oxide, and copper oxide. This configuration enables the semiconductor element to be better bonded to the board via a small piece of the thermal bonding sheet 10 (small piece 10' of the thermal bonding sheet).

The sinterable particles preferably include, as the conductive metal, at least one of silver and copper. This configuration enables the sinter precursor layer 2 to achieve better thermal conductivity and better electrical conductivity.

The sinterable particles preferably include silver as the conductive metal. The sinterable particles including silver have good oxidation resistance, and enable the sintering treatment to be suitably carried out even in an air atmosphere. Specifically, for example, the sintering treatment when bonding the semiconductor element such as the semiconductor chip X to the board can be suitably carried out in an air atmosphere. In contrast, when the sinterable particles include, for example, copper, the sintering treatment can be carried out as required in an inactive environment such as a nitrogen atmosphere to prevent the copper from being oxidized.

The sinterable particles can include a metal oxide. For example, the sinterable particles can have surface portions having a metal transformed into a metal oxide.

For example, the sinterable particles can each have a core-shell structure having a core portion and a shell portion covering the core portion. The core portion can include, as the main component, at least one of silver and copper. The shell portion can include, as the main component, gold, silver, silver oxide, or copper oxide. For example, the sinterable particles can be formed of silver particles with their surfaces at least partially covered with silver oxide, or can be formed of copper particles with their surfaces at least partially covered with copper oxide. The particles made of a plurality of kinds of metal can each be, for example, a particle having a core portion made of nickel, copper, silver, aluminum, or the like and a shell portion at least partially covering a surface of the core portion and made of gold, silver, copper, or the like.

Further, examples of the sinterable particles include composite particles including a metal and a material other than the metal. Examples of the composite particles include particles each having a core part formed of, for example a resin particle, and a surface part at least partially covering a surface of the core part and made of a metal such as nickel or gold. The core part can be made of a carbon material such as carbon black or a carbon nanotube. As the composite particles, employed can be, for example, metal particles with their surfaces subjected to surface treatment by a fatty acid.

When the sinterable particles include silver, more specifically, when the sinterable particles are silver particles, the silver particles can include a silver element and other elements being inevitable impurity elements (e.g., metal elements). Alternatively, the silver particles can be subjected to surface treatment (e.g., silane coupling treatment). Examples of the surface treatment agent for the silver particles include a fatty acid-based coating agent, an amine-based coating agent, and an epoxy-based coating agent.

As the silver particles, those silver particles having their surfaces treated with a coating agent (hereinafter possibly referred to as coating agent treated silver particles) are preferable in terms of the following aspects. Use of the coating agent treated silver particles as the sinterable particles can further increase affinity between the organic binder and the sinterable particles in the sinter precursor layer 2 before sintering treatment. This configuration can more sufficiently disperse the sinterable particles in the sinter precursor layer 2 before sintering treatment. As will be described later on the production of a semiconductor device, the sintering treatment for the sinter precursor layer 2 at a certain temperature or higher at least partially eliminates the organic binder from the sinter precursor layer 2.

Only one kind of the aforementioned sinterable particles can be employed, or two or more kinds of these can be employed in combination.

The sinterable particles have, for example, a needle shape, a thread shape, a spherical shape, or a plate shape (including a scale shape). Among these shapes, a spherical shape is preferable. The sinterable particles having a spherical shape can be more favorably dispersed in a varnish for obtaining the sinter precursor layer 2.

The sinterable particles are sintered to each other by the sintering treatment in which heating is carried out to a certain temperature. The sinterable particles are particles each having at least a part made of the conductive metal and fixed to each other when heated at a certain temperature. Thus, a heat transmission path is formed inside the sinter precursor layer 2 after the sintering treatment. In particular, the heat transmission path is formed in a thickness direction of the sinter precursor layer 2. This enables the sinter precursor layer 2 to have a relatively high heat conductivity (heat dissipation) after the sintering treatment.

The sinterable particles can be sinterable at a heating temperature of 400 °C or less. In other words, employed can be those sinterable particles with necking found on their outer surfaces when heated at a temperature of 400 °C or less.

The temperature at which the sinterable particles are sintered can be measured using a thermogravimetric and differential thermal analyzer. Specifically, the measurement is carried out using a thermogravimetric and differential thermal analyzer (for example, the differential thermal balance TG8120 manufactured by Rigaku Corporation) under the following conditions. A Tg curve and a DTA curve are obtained by the measurement. The temperature at the largest peak of the DTA curve found near a portion of the Tg curve beginning to decline is defined as the sintering temperature of the sinterable particles.

<Measurement conditions>
- Temperature rising rate: 10 °C/min
- Measurement atmosphere: Air
- Measurement temperature range: Ordinary temperature (23 ± 2 °C) to 500 °C

The sinterable particles including, as the conductive metals, gold, silver, copper, palladium, tin, or nickel, or an alloy thereof are sinterable at a heating temperature of 400 °C or less.

The sinterable particles have an average particle size of preferably 1 nm or more, more preferably 10 nm or more, more preferably 50 nm or more. This configuration enables the sinterable particles to have better dispersibilty in a later-described varnish for obtaining the sinter precursor layer 2. Thus, the sinter precursor layer 2 with the sinterable particles sufficiently dispersed therein can be prepared from the varnish. The sinterable particles have an average particle size of preferably 10000 nm or less, more preferably 3000 nm or less, further preferably 1000 nm or less, particularly preferably 500 nm or less. This configuration enables the sinter precursor layer 2 to have a flatter and smoother surface. The average particle size of the sinterable particles is determined according to the particle size distribution measurement method to be described in detail later. The above average particle size refers to the average particle size of all sinterable particles included in the sinter precursor layer 2.

The sinter precursor layer 2 includes preferably 60 mass % or more, more preferably 65 mass % or more, further preferably 70 mass % or more, most preferably 75 mass % or more, of the sinterable particles. The sinter precursor layer 2 includes preferably 99 mass % or less, more preferably 98 mass % or less, further preferably 97 mass % or less, of the sinterable particles. In another aspect, the sinter precursor layer 2 preferably includes 30 volume % or more and 70 volume % or less of the sinterable particles. The content percentage of the sinterable particles falling within the above range enables the sinter precursor layer 2 after the sintering treatment to exert sufficiently reliable bonding properties when the sinterable particles are sintered to each other through the sintering treatment to bond the semiconductor element such as the semiconductor chip X to the board.

The volume content percentage of the sinterable particles in the sinter precursor layer 2 is preferably higher than the volume content percentage of the sinterable particles in the close adhesion layer 1. This configuration can further densify a layer formed through the sintering treatment of the sinter precursor layer 2.

The content percentage (in mass %) of the sinterable particles in the sinter precursor layer 2 can be calculated from the measured ash content remaining after the sinter precursor layer 2 is burnt. For example, the measurement can be performed according to the steps below using a thermogravimetric analyzer (e.g., TG209F1). The measurement using the thermogravimetric analyzer is preferably performed in a nitrogen gas flow.
(1) A measurement sample of the sinter precursor layer 2 weighing about 50 mg is heated from room temperature (23 ± 2 °C) to 650 °C.
(2) The temperature is kept at 650 °C for 30 minutes to thereby thermally decompose the organic binder in the measurement sample.
(3) The mass ratio of the remaining component (ash content) to the weighed value (about 50 mg) of the measurement sample is calculated.

The content percentage (in volume %) of the sinterable particles in the sinter precursor layer 2 is calculated using an SEM observation image obtained by observing the cross section of the sinter precursor layer 2 with a scanning microscope, by dividing the cumulative area of the sinterable particles by the total area of the observation image.

In this embodiment, it is preferable that the sinter precursor layer 2 include, as the organic binder, a thermally decomposable binder (in particular thermally decomposable polymer binder) and a highly volatile binder. The highly volatile binder is an organic binder component that completes its weight reduction (i.e., that is entirely desorbed to a weight of 0%) at a lower temperature than that for the thermally decomposable polymer binder when measured by thermogravimetric analysis (TGA).

The thermally decomposable polymer binder is a binder thermally decomposable by sintering treatment. The thermally decomposable polymer binder also has a function to have the sinter precursor layer 2 held in a sheet shape before sintering treatment. In terms of more sufficiently exerting such a function, the thermally decomposable polymer binder is preferably solid at ordinary temperature (23 ± 2 °C). Examples of the thermally decomposable polymer binder include a polycarbonate resin and an acrylic resin. The sinter precursor layer 2 preferably includes, as the thermally decomposable polymer binder, at least one of the polycarbonate resin and the acrylic resin. The sinter precursor layer 2 can include only the polycarbonate resin as the thermally decomposable polymer binder.

Examples of the polycarbonate resin include an aliphatic polycarbonate having no aromatic structure such as a benzene ring but only an aliphatic chain between carbonate esters (-O-C(=O)-O-) of the main chain, and an aromatic polycarbonate including an aromatic structure between carbonate esters (-O-C(=O)-O-) of the main chain. Examples of the aliphatic polycarbonate include polyethylene carbonate and polypropylene carbonate. Examples of the aromatic polycarbonate include a polycarbonate with its main chain having a bisphenol A structure.

Examples of the acrylic resin include a (meth)acrylate alkyl ester polymer with its linear or branched alkyl portion having 4 to 18 carbon atoms. It should be noted that the term "(meth)acryl" includes both "acryl" and "methacryl".

Examples of the alkyl group (alkyl portion) of the (meth)acrylate ester include a methyl group, an ethyl group, a propyl group, an isopropyl group, an n-butyl group, a t-butyl group, an isobutyl group, an amyl group, an isoamyl group, a hexyl group, a heptyl group, a cyclohexyl group, a 2-ethylhexyl group, an octyl group, an isooctyl group, a nonyl group, an isononyl group, a decyl group, an isodecyl group, an undecyl group, a lauryl group, a tridecyl group, a tetradecyl group, a stearyl group, and an octadecyl group.

The acrylic resin can include, in its molecule, a polymerization unit derived from a different monomer other than the above (meth)acrylate ester. Examples of the different monomer include a carboxy group-containing monomer, an acid anhydride monomer, a hydroxy group-containing monomer, a sulfonic acid group-containing monomer, and a phosphoric acid group-containing monomer.

Examples of the carboxy group-containing monomer include acrylic acid, methacrylic acid, carboxyethyl acrylate, carboxypentyl acrylate, itaconic acid, maleic acid, fumaric acid, and crotonic acid. Examples of the acid anhydride monomer include maleic anhydride and itaconic anhydride. Examples of the hydroxy group-containing monomer include (meth)acrylate 2-hydroxyethyl, (meth)acrylate 2-hydroxypropyl, (meth)acrylate 4-hydroxybutyl, (meth)acrylate 6-hydroxyhexyl, (meth)acrylate 8-hydroxyoctyl, (meth)acrylate 10-hydroxydecyl, (meth)acrylate 12-hydroxylauryl, and (meth)acrylate 4-(hydroxymethyl)cyclohexylmethyl. Examples of the sulfonic acid group-containing monomer include styrene sulfonic acid, allyl sulfonic acid, 2-(meth)acrylamide-2-methylpropane sulfonic acid, (meth)acrylamide propane sulfonic acid, sulfopropyl (meth)acrylate, and (meth)acryloyloxynaphthalene sulfonic acid. Examples of the phosphoric acid group-containing monomer include 2-hydroxyethyl acryloyl phosphate.

In this embodiment, the highly volatile binder is preferably in a liquid state having a viscosity of 1 × 10⁵ Pa s or less at 23 °C. Such a viscosity is measured using a dynamic viscoelasticity measuring device (device name "HAAKE MARS III" manufactured by Thermo Fisher Scientific K.K.). Specifically, the viscosity is measured using parallel plates as a jig each having a diameter of 20 mm and disposed to have a gap therebetween of 100 µm, at a shear rate of 1 S⁻¹ in shearing by rotation.

Examples of the highly volatile binder include terpene alcohols, alcohols other than the terpene alcohols, alkylene glycol alkyl ethers, and ethers other than the alkylene glycol alkyl ethers.

Examples of the terpene alcohols include isobornyl cyclohexanol, cytronellol, geraniol, nerol, carveol, and α-terpineol. Examples of the alcohols other than the terpene alcohols include pentanol, hexanol, heptanol, octanol, 1-decanol, ethylene glycol, diethylene glycol, propylene glycol, butylene glycol, and 2,4-diethyl-1,5-pentanediol. Examples of the alkylene glycol alkyl ethers include ethylene glycol butyl ether, diethylene glycol methyl ether, diethylene glycol ethyl ether, diethylene glycol butyl ether, diethylene glycol isobutyl ether, diethylene glycol hexyl ether, diethylene glycol dimethyl ether, diethylene glycol diethyl ether, diethylene glycol dibutyl ether, diethylene glycol butyl methyl ether, diethylene glycol isopropyl methyl ether, triethylene glycol methyl ether, triethylene glycol dimethyl ether, triethylene glycol butyl methyl ether, propylene glycol propyl ether, dipropylene glycol methyl ether, dipropylene glycol ethyl methyl ether, dipropylene glycol propyl ether, dipropylene glycol butyl ether, and tripropylene glycol dimethyl ether. Examples of the ethers other than the alkylene glycol alkyl ethers include ethylene glycol ethyl ether acetate, ethylene glycol butyl ethyl acetate, diethylene glycol ethyl ether acetate, diethylene glycol butyl ethyl acetate, and dipropylene glycol methyl ether acetate.

These highly volatile binders can be individually used, or two or more of them can be used in combination.

As the highly volatile binder, the terpene alcohols are preferable, and isobornyl cyclohexanol among the terpene alcohols is more preferable, in terms of its stability at ordinary temperature.

Isobornyl cyclohexanol is referred to also as 4-[1,7,7-trimethylbicyclo[2.2.1]heptane-2-yl]cyclohexanol. Isobornyl cyclohexanol has a boiling point falling within a range of 308 °C or more and 318 °C or less. Isobornyl cyclohexanol has a vapor pressure at 25 °C of 0.00003 mmHg. Isobornyl cyclohexanol has characteristic physical properties as follows. Specifically, isobornyl cyclohexanol has properties that, when heated from ordinary temperature (23 ± 2 °C) to 600 °C in a 200 mL/min nitrogen gas flow at a temperature rising rate of 10 °C/min, isobornyl cyclohexanol begins significantly reducing its mass at 100 °C or more, and is volatilized and eliminated (i.e., no further mass reduction can be found) at 245 °C. Further, isobornyl cyclohexanol has properties of having a viscosity as extremely high as 1000000 mPa s at 25 °C but having a viscosity as relatively low as 1000 mPa·s at 60 °C. The mass reduction is a value obtained when the mass reduction percentage at a temperature at which the measurement begins (i.e., ordinary temperature) is 0%. As described above, isobornyl cyclohexanol having this extremely high viscosity at 25 °C enables the sinter precursor layer 2 to easily maintain its sheet shape at ordinary temperature. In contrast, isobornyl cyclohexanol at 60 °C has the relatively low viscosity as above and has tackiness. That is, the sinter precursor layer 2 including isobornyl cyclohexanol can sufficiently maintain its sheet shape at ordinary temperature and have tackiness at 60 °C or higher. Thus, the sinter precursor layer 2 including isobornyl cyclohexanol as the highly volatile binder has better temporary fixing properties to an adherend such as a board. In other words, it can be further suppressed after the semiconductor element is temporarily fixed to the adherend that the attached semiconductor element is displaced or that the sinter precursor layer 2 is lifted from the adherend. The semiconductor element is temporarily fixed to the adherend such as the board via the sinter precursor layer 2 at a temperature of, for example, 30 °C or more and to 200 °C or less. The temperature is preferably 50 °C or more, more preferably 70 °C or more. At such a temperature, isobornyl cyclohexanol has tackiness for the reason above. The temperature can be 150 °C or less, can be 125 °C or less.

The sinter precursor layer 2 can include 1 mass % or more, 2 mass % or more, 3 mass % or more of the organic binder. The sinter precursor layer 2 includes preferably 3 mass % or more, more preferably 5 mass % or more of the organic binder. The sinter precursor layer 2 can include 40 mass % or less, 35 mass % or less, 30 mass % or less of the organic binder. The sinter precursor layer 2 includes preferably 20 mass % or less, more preferably 10 mass % or less of the organic binder.

When the sinter precursor layer 2 includes the thermally decomposable polymer binder and the highly volatile binder as the organic binder, the proportion (in %) of the thermally decomposable polymer binder to the total of the thermally decomposable polymer binder and the highly volatile binder is preferably 5 mass % or more, more preferably 10 mass % or more, further preferably 20 mass % or more. The proportion (in %) is preferably 60 mass % or less, more preferably 50 mass % or less, further preferably 40 mass % or less. In the sinter precursor layer 2, the content of the highly volatile binder can be larger than the content of the thermally decomposable polymer binder.

The sinter precursor layer 2 includes preferably 0.01 mass % or more, more preferably 0.05 mass % or more, further preferably 0.10 mass % or more, particularly preferably 0.20 mass % or more, of the thermally decomposable polymer binder. The sinter precursor layer 2 includes preferably 20.0 mass % or less, more preferably 10.0 mass % or less, further preferably 7.5 mass % or less, particularly preferably 5.0 mass % or less, of the thermally decomposable polymer binder.

The sinter precursor layer 2 includes preferably 0.5 mass % or more, more preferably 1.0 mass % or more, further preferably 1.5 mass % or more, particularly preferably 2.0 mass % or more, of the highly volatile binder. The sinter precursor layer 2 includes preferably 20.0 mass % or less, more preferably 15.0 mass % or less, further preferably 10.0 mass % or less, of the highly volatile binder.

The sintering precursor layer 2 can have a single-layered structure. Alternatively, the sinter precursor layer 2 can have a multilayered structure formed of a plurality of layers laminated on each other.

In this embodiment, the sinter precursor layer 2 has a thickness of preferably 5 µm or more. The thickness of the sinter precursor layer 2 can be 300 µm or less, can be 200 µm or less, can be 100 µm or less. The sinter precursor layer 2 can have a larger thickness than that of the close adhesion layer 1.

The thickness of the sinter precursor layer 2 is calculated by measuring the thickness thereof at any five positions selected at random using a dial gauge (model R-205 manufactured by PEACOCK), followed by arithmetically averaging these thickness values.

Next, a detailed description will be given on the close adhesion layer 1 of the thermal bonding sheet 10 of this embodiment.

### [Close adhesion layer of thermal bonding sheet]

In this embodiment, the close adhesion layer 1 includes the sinterable particles and the organic binder, similar to the sinter precursor layer 2. Details of the sinterable particles and the organic binder have been as described above. Hereinafter, the description relating to the close adhesion layer will be given only on those points different from the points described for the sinter precursor layer 2. Thus, the same description as that for the sinter precursor layer 2 will not be repeated.

The particle size distribution measured for the sinterable particles included in the close adhesion layer 1 has at least two peaks. Specifically, the particle size distribution chart obtained by measuring the particle size distribution under the following measurement conditions has at least two hills respectively on a large particle size side and a small particle size side. The peaks of the respective hills are separated from each other. In the particle size distribution chart, for example, the horizontal axis represents a particle size in a range of 1 µm to 10,000 µm, and the vertical axis represents a frequency (%). When the hill has a peak at a height (frequency (%)) of less than 0.1%, such a hill is not regarded as the hill on the small particle size side.

For example, in the close adhesion layer 1 in which a powder having a larger average particle size (i.e., large particle group) and a powder having a smaller average particle size (i.e., small particle group) are mixed together, at least two hills appear in the particle size distribution chart as described above. In other words, the close adhesion layer 1 includes a powder of sinterable particles having a larger average particle size (i.e., large particle group) and a powder of sinterable particles having a smaller average particle size (i.e., small particle group). When producing the close adhesion layer 1 including the large particle group, at least the sinterable particles and the organic binder are mixed together to allow the large particle group having a relatively large particle size to crush the organic binder into small pieces, consequently achieving a relatively high uniformity inside the close adhesion layer 1. A material of the particles forming the large particle group and a material of the particles forming the small particle group can be the same as each other, or can differ from each other. It is preferable that at least part of the particles forming the large particle group and at least part of the particles forming the small particle group include the same metal element. The term "including the same metal element" means that each includes the same kind of metals, or a component including the same kind of metal elements (e.g., the same kind of metal oxides, or metal oxides of the same kind of metal elements having different oxidation numbers). This configuration allows the particles to be easily sintered inside the close adhesion layer 1 by the sintering treatment. Thus, the sinter precursor layer 2 can become a denser layer after the sintering treatment.

Details of the above particle size distribution measurement method are shown below.

### [Measurement conditions for particle size distribution measurement]

Measuring instrument: Laser diffraction and scattering type particle size distribution meter
(e.g., Microtrac MT3000II, manufactured by MicrotracBEL)

### (Pretreatment of measurement sample)

A measurement sample having a thin chip shape is collected using cryomicrotome at least once or more from a surface layer of the close adhesion layer 1 in the state of being frozen with liquid nitrogen. Thereafter, 0.1 g of the collected measurement sample is placed in a beaker, and 1 g of an alcohol-based dispersion solvent (known as "Solmix") is added thereto for dispersion treatment for 10 seconds using an ultrasonic dispersion machine. Thereafter, the measurement is performed using a laser diffraction and scattering type particle size distribution meter under the following conditions:

### (Setting of laser diffraction and scattering type particle size distribution meter)

Number of measurements: 2
Measurement period: 30 seconds
Set shape: True spherical shape
Measurement mode: Ag (reflect)
Specific gravity of particles: 10.5
Solvent for measurement: Ethanol
Refractive index of solvent: 1.36
Measurement temperature: 25 °C
Particle size distribution: Volume-based
Average particle size: Median diameter (D50)

The content percentage of the sinterable particles in the close adhesion layer 1 is, for example, 30 mass % or more, preferably 60 mass % or more. The content percentage of the sinterable particles in the close adhesion layer 1 is, for example, 95 mass % or less, preferably 90 mass % or less. The content percentage falling within the above numerical range can achieve better adhesiveness between the close adhesion layer 1 and an adherend such as a wafer. Such a content percentage also enables the close adhesion layer 1 after the sintering treatment to exert sufficiently reliable bonding properties when the sinterable particles are sintered to each other through the sintering treatment to bond the semiconductor element such as the semiconductor chip X to the board.

The content percentage of the sinterable particles in the close adhesion layer 1 is, for example, 5 volume % or more, preferably 15 volume % or more. The content percentage of the sinterable particles in the close adhesion layer 1 is, for example, 40 volume % or less, preferably 35 volume % or less. The content percentage falling within the above numerical range can achieve better adhesiveness between the close adhesion layer 1 and an adherend such as a wafer. The content percentage of the sinterable particles in the close adhesion layer 1 can be determined in the same manner as the aforementioned volume percentage of the sinterable particles in the sinter precursor layer 2.

The proportion of the large particle group to the sinterable particles included in the close adhesion layer 1 is preferably 5% or more and 30% or less on a volume % basis. The content percentage falling within the above numerical range can achieve better adhesiveness between the close adhesion layer 1 and an adherend such as a wafer. The proportion is a proportion of those sinterable particles defined to fall under the large particle group by the above particle size distribution measurement (laser diffraction and scattering type measurement) to all sinterable particles, and is calculated on a volume % basis. Specifically, out of the hill with the highest peak and the hill with the second highest peak in the particle size distribution, the hill on the large particle side is regarded as the hill of the large particle group of sinterable particles. Based on all of the plurality of hills appearing in the particle size distribution, the cumulative count number of all sinterable particles on a volume % basis and the cumulative count number of the hills of the large particle group are respectively calculated. Accordingly, the proportion of the large particle group to all sinterable particles is calculated as a numerical value [in %] where the cumulative count number of all sinterable particles on a volume basis is defined as 100%. When a peak curve extends upward from a zero point height in the vertical axis of the particle size distribution chart on either of both sides of a hill, the point at the zero point height of the peak curve is basically regarded as a boundary of the hill (that is, the start point or the end point of the hill). When the lowest point of a valley between two adjacent hills is located at a higher position than the zero point in the vertical direction of the particle size distribution chart (i.e., when the two adjacent hills partially overlap each other), a line drawn to pass the lowest point in parallel with the vertical axis is basically regarded as a boundary of the two adjacent hills. Further, the horizontal axis (the horizontal axis passing through the zero point in the vertical axis) is regarded as the baseline of each hill. The aforementioned proportion of the large particle group to the sinterable particles can be determined by calculating the count number in the portion surrounded by the boundaries set as above, the baseline, and the peak curve.

A ratio (P2/P1) of an average particle size P2 of the large particle group to an average particle size P1 of the small particle group included in the close adhesion layer 1 can be 10 or more and 1000 or less, 100 or less, 50 or less. The larger the ratio, the smaller pieces the organic binder is crushed into as described above, which can consequently achieve a relatively high uniformity inside the close adhesion layer 1. When three or more hills appear in the particle size distribution, the hill on the large particle side out of the hill with the highest peak and the hill with the second highest peak in the particle size distribution can be regarded as the hill of the large particle group of the sinterable particles while the other hill can be regarded as the hill of the small particle group of the sinterable particles. The average particle size P1 of the small particle group and the average particle size P2 of the large particle group refer to the particle size values at the respective peaks in the particle size distribution chart. In other words, it is preferable that, in the particle size distribution chart, the ratio (P2/P1) of the particle size value P2 at the peak of the large particle group to the particle size value P1 at the peak of the small particle group fall within the above range. The average particle size P1 of the small particle group (i.e., particle size value P1 at the peak of the small particle group) can be, for example, 0.005 µm or more and 1 µm or less. The average particle size P2 of the large particle group (i.e.,the particle size value P2 at the peak of the large particle group) can be, for example, 0.5 µm or more and 10 µm or less. The hills with their respective peaks falling within the above ranges can be regarded as the hills of the large particle group and the small particle group, respectively.

The close adhesion layer 1 can include 1 mass % or more, 2 mass % or more of the organic binder. The close adhesion layer 1 can include 40 mass % or less, 35 mass % or less of the organic binder.

When the close adhesion layer 1 includes the thermally decomposable polymer binder and the highly volatile binder as the organic binder, the proportion (in %) of the thermally decomposable polymer binder to the total of the thermally decomposable polymer binder and the highly volatile binder is preferably 5 mass % or more, more preferably 10 mass % or more. Such a proportion (in %) is preferably 60 mass % or less, more preferably 50 mass % or less. In the close adhesion layer 1, the content of the highly volatile binder can be larger than the content of the thermally decomposable polymer binder.

The close adhesion layer 1 can include 0.01 mass % or more, 0.05 mass % or more of the thermally decomposable polymer binder. The close adhesion layer 1 can include 20.0 mass % or less, 10.0 mass % or less of the thermally decomposable polymer binder.

The close adhesion layer 1 can include 0.5 mass % or more, 1.5 mass % or more of the highly volatile binder. The close adhesion layer 1 can include 40.0 mass % or less, 30.0 mass % or less of the highly volatile binder.

The close adhesion layer 1 can have a thickness of, for example, 1 µm or more and 100 µm or less. The thickness of the close adhesion layer 1 is preferably 2 µm or more. The thickness of the close adhesion layer 1 is preferably 50 µm or less, more preferably 25 µm or less, further preferably 20 µm or less. The thickness of the close adhesion layer 1 is measured in the same manner as in the thickness of the sinter precursor layer 2 as aforementioned.

Next, a detail description will be given on the component transferring prevention layer 3 of the thermal bonding sheet 10 of this embodiment. The thermal bonding sheet 10 can be provided with or without the component transferring prevention layer 3.

### [Component transferring prevention layer of thermal bonding sheet]

In this embodiment, the component transferring prevention layer 3 of the thermal bonding sheet 10 functions as a support body of the thermal bonding sheet 10. The component transferring prevention layer 3 includes at least a resin. The component transferring prevention layer 3 is formed of, for example, a plastic film.

Examples of the material of the plastic film include a polyolefin resin, a polyester resin, a polyurethane resin, a polycarbonate resin, a polyether ether ketone resin, a polyimide resin, a polyether imide resin, a polyamide resin, a wholly aromatic polyamide resin, a polyvinyl chloride resin, a polyvinylidene chloride resin, a polyphenyl sulfide resin, an aramid resin, a fluororesin, a cellulose-based resin, and a silicone resin. The component transferring prevention layer 3 can be formed of a single material, or can be formed of two or more materials.

Examples of the polyolefin resin include a low-density polyethylene resin, a linear low-density polyethylene resin, a middle-density polyethylene resin, a high-density polyethylene resin, an ultralow-density polyethylene resin, a random copolymer polypropylene resin, a block copolymer polypropylene resin, a homopolypropylene resin, a polybutene resin, a polymethylpentene resin, an ethylene-vinyl acetate copolymer resin, an ionomer resin, an ethylene-butene copolymer resin, and an ethylene-hexene copolymer resin. Examples of the polyester resin include a polyethylene terephthalate resin, a polyethylene naphthalate resin, and a polybutylene terephthalate resin.

The component transferring prevention layer 3 can have a single-layered structure, or can have a multilayered structure. The single-layered structure means a structure made of a single material. For example, the component transferring prevention layer 3 in which two or more layers each made of a single material are laminated on each other has a single-layered structure. In contrast, the component transferring prevention layer 3 in which two or more layers respectively made of different materials are laminated on each other has a multilayered structure.

When the component transferring prevention layer 3 is a plastic film, the component transferring prevention layer 3 can be a non-oriented film, or can be an oriented film. The oriented film can be a uniaxially-oriented film, or can be a biaxially-oriented film. The component transferring prevention layer 3 can be a release liner whose surface in contact with the sinter precursor layer 2 is subjected to release treatment. One surface of the component transferring prevention layer 3 in contact with the sinter precursor layer 2 is, for example, coated with a releasing agent. In this case, the small piece of the sinter precursor layer 2 (i.e., small piece 2' of the sinter precursor layer) can be easily separated from the one surface of the component transferring prevention layer 3 (i.e., release liner) in producing the semiconductor device.

The thickness of the component transferring prevention layer 3 is preferably 2 µm or more, more preferably 5 µm or more, further preferably 10 µm or more. The thickness of the component transferring prevention layer 3 is preferably 5000 µm or less, more preferably 4000 µm or less, further preferably 3000 µm or less. The thickness of the component transferring prevention layer 3 is measured in the same manner as in the thickness of the sinter precursor layer 2 as aforementioned.

As shown in, for example, Fig. 1B, a dicing tape-equipped thermal bonding sheet 100 of this embodiment includes the thermal bonding sheet 10, and the dicing tape 20 superposed on one surface of the thermal bonding sheet 10. In the dicing tape-equipped thermal bonding sheet 100, the sinter precursor layer 2 is disposed between the close adhesion layer 1 and the dicing tape 20.

The dicing tape 20 includes a substrate layer 21 and an adhesive layer 22 superposed on one surface of the substrate layer 21. The substrate layer 21 of the dicing tape 20 is formed of, for example, a resin film, and the adhesive layer 22 is formed of, for example, an adhesive resin composition including, e.g., an acrylic resin. The dicing tape 20 of this kind is commercially available. When the thermal bonding sheet 10 includes the component transferring prevention layer 3, the component transferring prevention layer 3 is, for example, superposed on the adhesive layer 22 of the dicing tape 20. In contrast, when the thermal bonding sheet 10 includes no component transferring prevention layer 3, the sinter precursor layer 2 of the thermal bonding sheet 10 is, for example, superposed on the adhesive layer 22 of the dicing tape 20.

Next, a description will be given on a method for producing the aforementioned thermal bonding sheet.

The method for producing the thermal bonding sheet includes, for example: a step of fabricating the sinter precursor layer; a step of fabricating the close adhesion layer; and a step of attaching the sinter precursor layer and the close adhesion layer to each other. The method further includes a step of superposing the component transferring prevention layer on one surface of the sinter precursor layer as necessary.

The step of fabricating the sinter precursor layer includes, for example: a step of preparing a varnish including sinterable particles containing a conductive metal, an organic binder, and an organic solvent; and a step of fabricating the sinter precursor layer by volatilizing the organic solvent from the varnish. The step of fabricating the close adhesion layer includes, for example: a step of preparing a varnish including sinterable particles containing a conductive metal, an organic binder, and an organic solvent; and a step of fabricating the close adhesion layer by volatilizing the organic solvent from the varnish.

The step of fabricating the sinter precursor layer and the step of fabricating the close adhesion layer are substantially identical to each other. Specific examples of each step are as follows. In the step of preparing the varnish, for example, the sinterable particles, the organic binder, and the organic solvent are mixed together to disperse the sinterable particles in the organic solvent and dissolve the organic binder in the organic solvent, thereby preparing the varnish.

As the organic solvent, for example, alcohols such as ethanol or ketones such as methyl ethyl ketone (MEK) can be used.

The mixing temperature for preparing the varnish is not particularly limited, and is, for example, 5 °C or more and 70 °C or less. No method for mixing the varnish is particularly limited, and any mixing method using a general stirrer can be employed.

The solid content concentration of the varnish is, for example, 30 mass % or more and 80 mass % or less. The solid content concentration of the varnish can be 40 mass % or more, can be 50 mass % or more. The solid content concentration of the varnish can be 70 mass % or less. The solid content refers to the component obtained by removing the organic solvent from the varnish, and is, for example, the total of the sinterable particles and the organic binder.

The varnish has a viscosity at 23 °C of, for example, 1.0 [Pa s] or more and 7.0 [Pa s] or less. Such a viscosity is measured using an E-type viscometer (e.g., device name "RE-85" manufactured by Toki Sangyo Co., Ltd). Specifically, a "1°34' × R24" cone rotor as a jig is used with a measurement sample in an amount of 1.1 mL at a rotation speed of 1.0 rpm for the measurement of the viscosity.

In the step of fabricating the sinter precursor layer, for example, the varnish is applied with a certain thickness onto the release liner to form a coating film. Subsequently, the coating film is heated to volatilize the organic solvent. In the step of fabricating the close adhesion layer, for example, the varnish is applied with a certain thickness onto the release liner to form a coating film. Subsequently, the coating film is heated to volatilize the organic solvent.

In the step of attaching the sinter precursor layer and the close adhesion layer to each other, the sinter precursor layer on the release liner and the close adhesion layer on the release liner are superposed on each other. The release liner adhering to the sinter precursor layer is removed as necessary, to superpose the component transferring prevention layer on the exposed surface of the sinter precursor layer. Alternatively, the release liner adhering to the sinter precursor layer can remain attached for serving as the component transferring prevention layer.

The thermal bonding sheet 10 produced as above can be used as, for example, an auxiliary member for producing the semiconductor device.

### [Method for using thermal bonding sheet (method for producing semiconductor device)]

Next, a description will be given on one example of a method for producing a semiconductor device using the thermal bonding sheet 10 according to this embodiment, with reference to the drawings. In the method for producing the semiconductor device, an adherend to which the close adhesion layer 1 or the sinter precursor layer 2 of the thermal bonding sheet 10 is attached is not limited to the following. Examples of the adherend include a semiconductor wafer, a board, a heat sink, and a clip (used in so called clip bonding). Examples of the adherend further include a metal pad and a metal plate. For example, a layered product (first layered product) of the close adhesion layer 1 and the sinter precursor layer 2 can be attached to one surface of a semiconductor chip to bond the semiconductor chip and the adherend to each other via the first layered product, and further a layered product (second layered product) of the close adhesion layer 1 and the sinter precursor layer 2 can be attached to an other surface of the semiconductor chip. Then, the semiconductor chip and the metal pad or the metal plate can be bonded to each other via the second layered product. In such a case, the configuration can be, for example, such that the close adhesion layer 1 of the first layered product is attached to the semiconductor wafer (semiconductor chip) and the close adhesion layer 1 of the second layered product is attached to the metal pad or the metal plate.

The method for producing the semiconductor device according to this embodiment is carried out using, for example: a semiconductor wafer W for obtaining a plurality of the semiconductor chips X; a board having a plurality of mounting areas on which the plurality of semiconductor chips X are to be respectively mounted; the thermal bonding sheet 10; the dicing tape 20 (see Fig. 1B); and a pressing member used for temporarily fixing each of the plurality of semiconductor chips X to each corresponding one of the plurality of mounting areas.

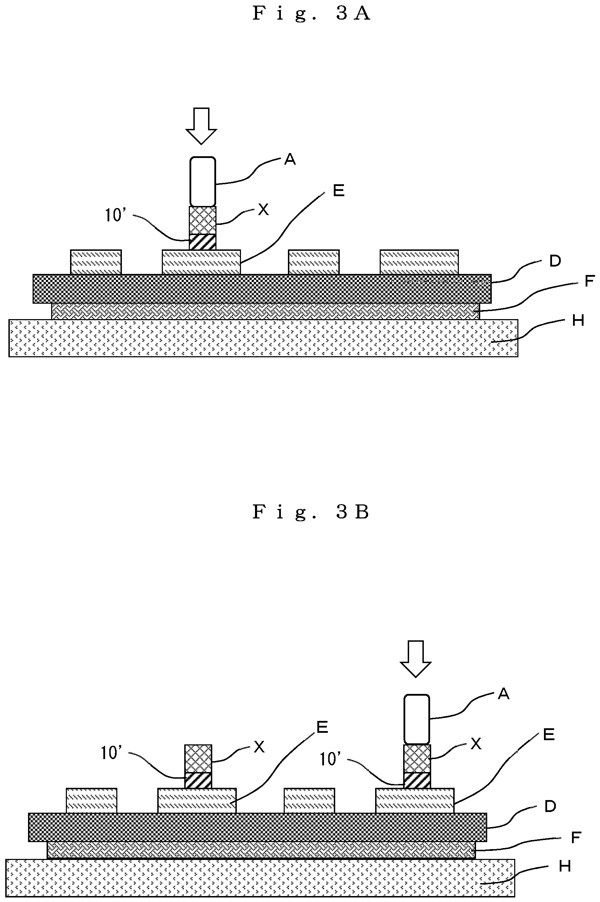

A description hereinafter will be given by taking, for example, the case where the semiconductor chips X are mounted on the board such as a DBC (Directed Bonded Copper) board or an AMB (Active Metal Brazing) board using a collet A as the pressing member. Each of these boards includes a ceramic insulating layer D, and a copper die pad E and a copper thin layer F disposed on the respective sides of the ceramic insulating layer D. The copper die pad E is an area on which each of the semiconductor chips X is mounted (hereinafter also referred to simply as mounting area) (see Fig. 3A).

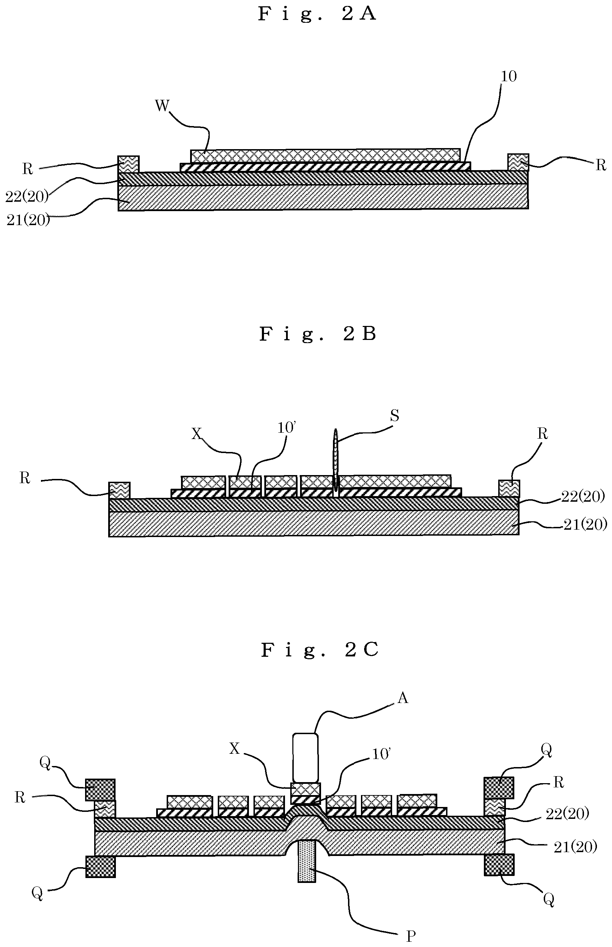

First, the semiconductor wafer W is cut on the dicing tape 20 to obtain the plurality of semiconductor chips X out of the semiconductor wafer W (see Fig. 2A and Fig. 2B). Specifically, the semiconductor wafer W is attached to an exposed surface of the thermal bonding sheet 10, and a dicing ring R is attached to the adhesive layer 22 of the dicing tape 20. Then, the semiconductor wafer W is divided into a plurality of small pieces to obtain the semiconductor chips X. More specifically, the thermal bonding sheet 10 and the semiconductor wafer W are cut (so-called fully cut) into small pieces using, for example, a dicing saw S to fabricate the small pieces 10' of the thermal bonding sheet and the semiconductor chips X on the dicing tape 20. Used as the dicing tape 20 can be any commercially available product. When the thermal bonding sheet 10 includes the component transferring prevention layer 3 and the component transferring prevention layer 3 is a release liner, the close adhesion layer 1 and the sinter precursor layer 2, which are the layers of the thermal bonding sheet 10 other than the component transferring prevention layer 3, can be cut (so-called half cut). In this case, each of the small pieces of the sinter precursor layer 2 (i.e., small piece 2' of the sinter precursor layer) can be separated from one surface of the component transferring prevention layer 3 (i.e., release liner) to pick up the semiconductor chip X and the small piece 10' of the thermal bonding sheet as will be described later.

The obtained semiconductor chip X has, for example, a rectangular sheet shape. The semiconductor chip X has a thickness of, for example, 10 µm or more and 500 µm or less. The semiconductor chip X has a thickness of preferably 20 µm or more and 400 µm or less. The semiconductor chip X has an area of, for example, 0.01 mm² or more and 1000 mm² or less as viewed from one side in the thickness direction. Such an area is preferably 0.04 mm² or more and 500 mm² or less.

Next, as shown in Fig. 2C, the semiconductor chip X to which the small piece 10' of the thermal bonding sheet is attached is separated from the adhesive layer 22 of the dicing tape 20. Specifically, in the state where the dicing tape 20 to which the dicing ring R is attached is fixed with a holding tool Q, a pin member P is raised to push up, via the dicing tape 20, the semiconductor chip X as a target to be picked up and the small piece 10' of the thermal bonding sheet. The pushed up semiconductor chip X and small piece 10' of the thermal bonding sheet are held by the collet A.

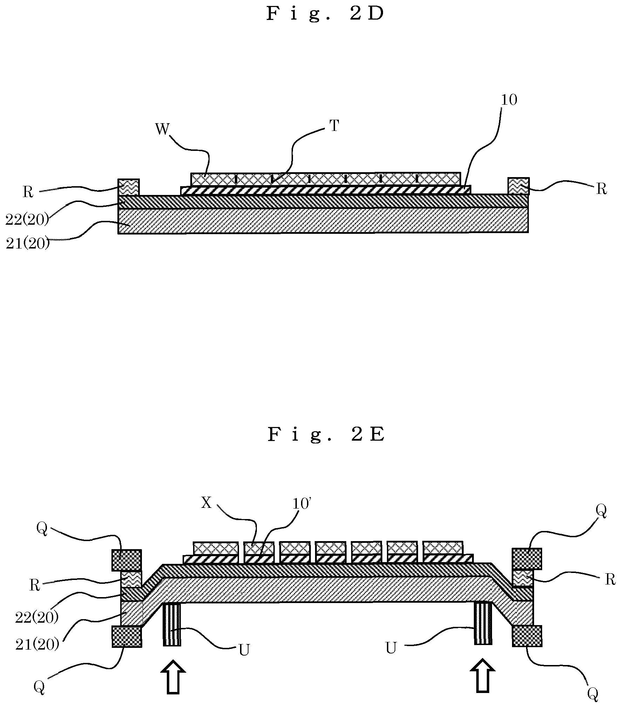

In substitution for the steps as shown in Fig. 2A and Fig. 2B, the steps as shown below can also be carried out. Specifically, as shown in Fig. 2D, the semiconductor wafer W on the dicing tape 20 is subjected to stealth dicing to thereby form a plurality of fragile areas T for cutting inside the semiconductor wafer W. In the stealth dicing processing, the inside of the semiconductor wafer W is irradiated with a laser beam with a proper condensing point. This forms the fragile areas T inside the semiconductor wafer W through ablation by multiphoton absorption. The semiconductor wafer W can be made thinner by grinding a back surface of the semiconductor wafer W before or after the stealth dicing processing.

As shown in, for example, Fig. 2E, the semiconductor wafer W after the stealth dicing processing is to be cut along the fragile areas T by expansion of the dicing tape 20. Specifically, first, the dicing tape 20 on which the semiconductor wafer W after the stealth dicing processing is mounted is fixed to the holding tool Q of an expanding apparatus. Next, the dicing tape 20 is stretched (expanded) to spread the area of the dicing tape 20 to thereby cut and divide the semiconductor wafer W. Specifically, a plurality of push-up members U are raised from a lower side of the dicing tape 20 to stretch (expand) the dicing tape 20 in its plane direction. The temperature condition during the expansion is, for example, -20 °C or more and 70 °C or less. Such expansion forms cracks in the fragile areas T in the semiconductor wafer W to divide the semiconductor wafer W into small pieces, thus obtaining the semiconductor chips X. Thereafter, the push-up members U are lowered to release the expansion state of the dicing tape 20. After the expansion, a portion of the dicing tape 20 on an outer peripheral side of the group of semiconductor chips X can be heated and shrunk. The temperature for the heating is, for example, 100 °C or more and 300 °C or less. Carrying out such steps can also form the semiconductor chips X on the dicing tape 20. Then, as shown in Fig. 2C, the semiconductor chip X to which the small piece 10' of the thermal bonding sheet is attached is separated from the adhesive layer 22 of the dicing tape 20.

Next, a separate board (e.g., layered product of the ceramic insulating layer D, the copper die pad E, and the copper thin layer F) is placed on a stage H (see Fig. 3A). Then, the collet A set at any temperature within a range of 25 °C or more and 150 °C or less while holding the semiconductor chip X is caused to descend in a vertical direction to bring the small piece 10' of the thermal bonding sheet attached to the semiconductor chip X into abutting contact with the copper die pad E. Subsequently, the semiconductor chip X is pressed at the copper die pad E using the collet A. The operations above are carried out to temporarily fix one semiconductor chip X to the copper die pad E, followed by repeatedly carrying out the same operations. The plurality of semiconductor chips X are thus temporarily fixed to the copper die pad E via the small piece 10' of the thermal bonding sheet (see Fig. 3A and Fig. 3B). The pressure at which each of the semiconductor chips X is pressed at the copper die pad E is preferably 0.01 MPa or more and 50 MPa or less, more preferably 0.1 MPa or more and 30 MPa or less.

The board as an adherend of the small piece 10' of the thermal bonding sheet can be a lead frame. A general lead frame can be used as the lead frame. For example, a lead frame formed of a Cu frame plated with Ag, or a lead frame formed of a Cu frame plated with Ni, Pd, and Au in this order (Palladium Pre-Plated Lead Frame; Pd-PPF) can be employed.

When each of the semiconductor chips X is temporarily fixed, the collet A can be heated to a temperature at which the sinterable particles included in the small piece 10' of the thermal bonding sheet can be sintered. The sinterable particles included in the small piece 10' of the thermal bonding sheet can be thereby subjected to primary sintering treatment.

When the sinterable particles included in the small piece 10' of the thermal bonding sheet can be sintered at a heating temperature of 400 °C or less, the collet A is preferably heated to a temperature of 200 °C or more. The collet A heated to 200 °C or more enables the sinterable particles to be more sufficiently sintered to each other. Accordingly, the semiconductor chip X can be more firmly bonded to the copper die pad E via the small piece 10' of the thermal bonding sheet. In other words, the semiconductor chip X is imparted an increased bonding reliability to the board.

When the above primary sintering treatment is carried out, it is preferable that the collet A be heated rapidly (i.e., within about 5 seconds). The collet A is preferably heated at a temperature rising rate of 30 °C/sec or more, more preferably heated at a temperature rising rate of 45 °C/sec or more.

The primary sintering treatment can be carried out not only by heating the collet A but also by heating the stage H as well at the temperature as above. This enables the small piece 10' of the thermal bonding sheet to be heated from both sides in the thickness direction, and thus enables the sinterable particles to be sufficiently sintered to each other. Accordingly, the semiconductor chip X can be more sufficiently bonded to the copper die pad E via the small piece 10' of the thermal bonding sheet. In other words, the semiconductor chip X is imparted a further increased bonding reliability to the board.

The heated stage H preferably has such a temperature or less as to suppress the copper die pad E or the copper thin layer F from being oxidized. The heating temperature of the stage H is preferably 150 °C or less.

When the primary sintering treatment is carried out as above, for example, the temperature of the collet A can be decreased to a temperature at which the sinterable particles are hardly sintered to each other (e.g., 50 °C) by lifting up the collet A after the primary sintering treatment to make a clearance between the semiconductor chip X and the collet A. When each of all small pieces 10' of the thermal bonding sheet is subjected to the primary sintering treatment, bonding wires can be bonded to required positions after all the semiconductor chips X are bonded.

In the method for producing the semiconductor device according to this embodiment, a heating step of heating the small piece 10' of the thermal bonding sheet to a temperature at which the sinterable particles are sinterable to each other can be carried out after the plurality of semiconductor chips X are temporarily fixed to the board. In the heating step, heating can be carried out while compression force is applied in the thickness direction to at least any one of the plurality of the small pieces 10' of the thermal bonding sheet. When the primary sintering treatment as described above is carried out, the heating step corresponds to a secondary sintering treatment. In other words, the sintering treatment can be carried out by both the primary sintering treatment above and the secondary sintering treatment (i.e., the above heating step).

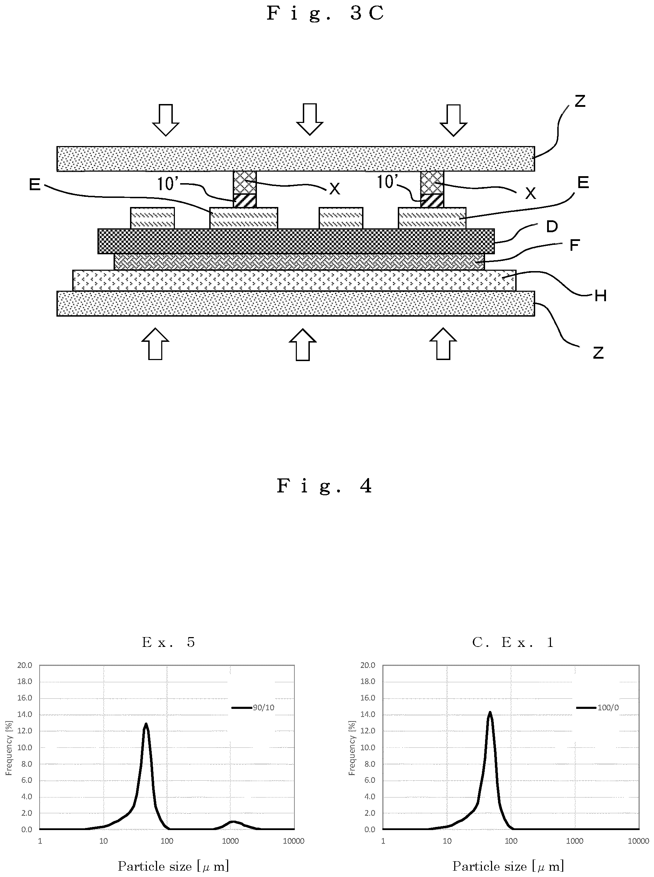

More specifically, in the method for producing the semiconductor device according to this embodiment, the sintering treatment can be carried out as follows. In the heating step of the sintering treatment, for example, heating is carried out while at least any one of the plurality of small pieces 10' of the thermal bonding sheet is pressed in its thickness direction. Specifically, after the semiconductor chips X are temporarily fixed, heating can be carried out using a heating and pressurizing device configured to be capable of heating while compression force is applied in the thickness direction to the small piece 10' of the thermal bonding sheet. The heating and pressurizing device is composed of two flat plates Z as shown in, for example, Fig. 3C. The two flat plates Z are placed to allow the stage H, the board (the ceramic insulating layer D, the copper die pad E, and the copper thin layer F), and the plurality of semiconductor chips X to be sandwiched therebetween. Then, the small pieces 10' of the thermal bonding sheet are heated while being pressed by applying such force as to make small a distance between the two heated flat plates. The heating step thus carried out enables the plurality of small pieces 10' of the thermal bonding sheet to be heated while being pressed, thereby being capable of firmly bonding the semiconductor chips X to the board (copper die pad E) via the respective small pieces 10' of the thermal bonding sheet. Accordingly, the semiconductor chips X can be imparted an improved bonding reliability to the board. Following such a heating step, bonding wires can be bonded to required positions.

In the heating step, in contrast, after all those semiconductor chips X to be bonded are temporarily fixed, the small pieces 10' of the thermal bonding sheet can be heated without applying compression force in the thickness direction to the respective small pieces 10' of the thermal bonding sheet. In so doing, the small pieces 10' of the thermal bonding sheet are heated at a temperature at which the sinterable particles included in the small pieces 10' of the thermal bonding sheet are made sinterable (for example, any temperature within a range of 200 °C or more and 400 °C or less). The heating can be carried out by heating the stage H, or carried out using an oven or a reflow furnace. Such a heating step still enables the semiconductor chips X to be firmly bonded to the board (copper die pad E) via the respective small pieces 10' of the thermal bonding sheet. Accordingly, the semiconductor chips X can be imparted an increased bonding reliability to the board.

In the method for producing the semiconductor device according to this embodiment, further steps can be carried out. For example, a wire bonding step of electrically connecting a part of each of the semiconductor chips X and a part of the board to each other can be carried out. Further, a sealing step of sealing, for example, the semiconductor chip X and the small piece 10' of the thermal bonding sheet using a thermosetting resin such as an epoxy resin can be carried out. In the sealing step, heating treatment is performed at a temperature of, for example, 150 °C or more and 200 °C or less to allow the curing reaction of the thermosetting resin to proceed.

The thermal bonding sheet of this embodiment has been described as above, but the present invention is not limited to the above-described thermal bonding sheet. That is, various forms used in, for example, general thermal bonding sheets can be employed without impairing the effect of the present invention.

The matters disclosed herein include the following.
(1) A thermal bonding sheet including: a sinter precursor layer including sinterable particles; and a close adhesion layer superposed on one surface of the sinter precursor layer, in which the close adhesion layer includes an organic binder and the sinterable particles, and a content percentage of the sinterable particles in the close adhesion layer is 5 volume % or more and 40 volume % or less, and a particle size distribution measured for the sinterable particles included in the close adhesion layer has at least two peaks. The thermal bonding sheet configured as above has good dispersibility of the organic binder in the close adhesion layer.
(2) The thermal bonding sheet according to (1) above, in which a volume content percentage of the sinterable particles in the sinter precursor layer is higher than a volume content percentage of the sinterable particles in the close adhesion layer.
(3) The thermal bonding sheet according to (1) or (2) above, in which the sinter precursor layer includes 30 volume % or more and 70 volume % or less of the sinterable particles.
(4) The thermal bonding sheet according to any of (1) to (3) above, in which the close adhesion layer includes 15 volume % or more and 35 volume % or less of the sinterable particles.
(5) The thermal bonding sheet according to any of (1) to (4) above, in which among a hill with a highest peak and a hill with a second highest peak in the particle size distribution, a hill on a large particle side represents a hill of a large particle group of the sinterable particles, and a proportion of the sinterable particles in the large particle group to the sinterable particles included in the close adhesion layer is 5% or more and 30% or less based on volume %.
(6) The thermal bonding sheet according to any of (1) to (5) above, in which both the sinter precursor layer and the close adhesion layer include a thermally decomposable binder as the organic binder.
(7) The thermal bonding sheet according to any of (1) to (6), in which the sinter precursor layer has a thickness of 5 µm or more and 100 µm or less, and the close adhesion layer has a thickness of 2 µm or more and 20 µm or less.
(8) A dicing tape-equipped thermal bonding sheet including: the thermal bonding sheet according to any of (1) to (7) above; and a dicing tape superposed on one surface of the thermal bonding sheet, in which the sinter precursor layer of the thermal bonding sheet is disposed between the close adhesion layer and the dicing tape.
(9) The dicing tape-equipped thermal bonding sheet according to (8) above, further including a component transferring prevention layer, in which the component transferring prevention layer is disposed between the sinter precursor layer and the dicing tape.

### EXAMPLES

Next, the present invention will be described in more detail by way of experimental examples. The following examples are intended to illustrate the present invention in further detail, and are not intended to limit the scope of the present invention.

### (Materials of sinter precursor layer)

### [Sinterable particles]

- First silver particles (small particle group):
   Average particle size of 60 nm, manufactured by DOWA ELECTRONICS MATERIALS CO., LTD.
- Second silver particles (large particle group):
   Average particle size of 1100 nm, manufactured by Mitsui Mining & Smelting Co., Ltd.

### [Organic binders]

- Thermally decomposable polymer binder: Polycarbonate resin: Product name: "QPAC 40" manufactured by Empower Materials
- Highly volatile binder: Isobornyl cyclohexanol
   Product name "Terusolve MTPH" manufactured by NIPPON TERPENE CHEMICALS, INC.
- Organic solvent: Methyl ethyl ketone (MEK) [Release liner]
- One pair of release treatment films (Product name "MRA 38" manufactured by Mitsubishi Chemical Corporation)

### (Example 1)

### [Fabrication of sinter precursor layer]

The first silver particles (90 mass parts), the second silver particles (10 mass parts), the thermally decomposable polymer binder (4 mass parts), and the highly volatile binder (12 mass parts) were dissolved or suspended in methyl ethyl ketone (MEK) to prepare a varnish. Specifically, a hybrid mixer (model "HM-500" manufactured by Keyence Corporation) was used and the mixture was stirred in a stirring mode for three minutes. Next, one surface of one of the pair of release liners was coated with the varnish, followed by being heated at 110 °C for three minutes to thereby form a sinter precursor layer having a thickness of 25 µm.

### [Fabrication of close adhesion layer]

The first silver particles (80 mass parts) and the second silver particles (20 mass parts) respectively measured in amounts shown in Table 1 were obtained, and these silver particles, the thermally decomposable polymer binder (13 mass parts), and the highly volatile binder (37 mass parts) were dissolved or suspended in methyl ethyl ketone (MEK) to prepare a varnish in the same manner as above. Next, one surface of the other one of the pair of release liners was coated with the varnish, followed by being heated at 110 °C for three minutes to thereby form a close adhesion layer having a thickness of 10 µm. As a result of measuring the content percentage of all sinterable particles in the close adhesion layer by the above method, the content percentage of the total of the first silver particles and the second silver particles in the close adhesion layer was 30 volume % in Example 1.

### [Fabrication of thermal bonding sheet]

The sinter precursor layer on the release liner and the close adhesion layer on the release liner, which were fabricated as above, were attached to each other to produce a thermal bonding sheet.

### (Examples 2 to 7 and Comparative Example 1)

Each thermal bonding sheet was produced in the same manner as in Example 1, except that the composition was changed to the corresponding composition shown in Table 1 and Table 2. Table 1 and Table 2 show the compositions included in the respective close adhesion layers according to Examples and Comparative Examples.

**Table 1**

| Close adhesion layer | Ex. 1 | Ex. 2 | Ex. 3 | Ex. 4 |
|---|---|---|---|---|
| *1 [volume %] | 30 | 40 | 35 | 15 |
| *2 [%] (proportion in volume content percentage) | 20 | 20 | 20 | 20 |
| No. of hills in particle size distribution chart | 2 hils | 2 hills | 2 hills | 2 hills |

| Evaluation result of thermal bonding sheet (close adhesion layer) | | | | |
|---|---|---|---|---|
| Evaluation by SAT test | Good | Good | Good | Good |
| Peeling test from wafer | 7.7 [N/10 mm] | 1.5 [N/10 mm] | 4.5 [N/10 mm] | 9.0 [N/10 mm] |

| | | | | |
|---|---|---|---|---|
| *1: Content percentage of the total of the first silver particles and the second silver particles in the close adhesion layer *2: Proportion of the second silver particles to the sum of the first silver particles and the second silver particles | | | | |

**Table 2**

| Close adhesion layer | Ex. 5 | Ex. 6 | Ex. 7 | C. Ex. 1 |
|---|---|---|---|---|
| *1 [volume %] | 30 | 30 | 30 | 30 |
| *2 [%] (proportion in volume content percentage) | 10 | 30 | 40 | 0 |
| No. of hills in particle size distribution chart | 2 hills | 2 hills | 2 hills | 1 hill |

| Evaluation result of thermal bonding sheet (close adhesion layer) | | | | |
|---|---|---|---|---|
| Evaluation by SAT test | Good | Good | Good | Bad |
| Peeling test from wafer | 7.9 [N/10 mm] | 7.2 [N/10 mm] | 6.5 [N/10 mm] | 8.9 [N/10 mm] |

| | | | | |
|---|---|---|---|---|
| *1: Content percentage of the total of the first silver particles and the second silver particles in the close adhesion layer *2: Proportion of the second silver particles to the sum of the first silver particles and the second silver particles | | | | |

### [Particle size distribution measurement of sinterable particles included in the close adhesion layer]

A particle size distribution was measured for the sinterable particles included in the close adhesion layer of each of the thermal bonding sheets produced as above, according to the measurement method and the measurement conditions described above. The measurement results are shown in Table 1 and Table 2. For example, in Example 1, the proportion of the second silver particles (large particle group) to all sinterable particles in the close adhesion layer was 20% on the basis of the volume content percentage. For the close adhesion layer of each of Examples, two hills were found in the particle size distribution chart. Fig. 4 shows specific examples (i.e., Example 5 and Comparative Example 1) of the particle size distribution charts after the measurement. For the close adhesion layer of Comparative Example 1, in contrast, only one hill was found in the particle size distribution chart.

### <Scanning acoustic tomography (SAT) test (evaluation of uniformity of close adhesion layer)>

A Cu board (20 mm × 20 mm × 3 mm thick) plated with Ag (5 µm thick), and a Si chip (5 mm × 5 mm × 0.2 mm thick) plated with Ti (0.1 µm thick) / Ag (0.75 µm thick) were prepared. Each thermal bonding sheet (including only the sinter precursor layer and the close adhesion layer) was placed to be sandwiched between the prepared Cu board and the Si chip to fabricate a testing layered product. Then, the testing layered product was subjected to sinter bonding treatment under the conditions of 300 °C / 10 MPa / 2.5 minutes. For the layered product after the sintering treatment, the bonding states at an interface between the Cu board and the sintered close adhesion layer and an interface between the Si chip and the sintered close adhesion layer were evaluated using an ultrasonic flaw detection image.
Apparatus: "FineSAT 200" manufactured by Hitachi Power Solutions Co., Ltd. Probe: PQ2-50-13 (reflection mode)
Number of measurement points: 600×600 (within 21 mm × 21 mm square)
Judging criteria: (Good) Image in uniform color across the entire bonding area (Bad) 10% or more in area proportion of a portion with weak reflection of ultrasonic waves within the bonding area was found

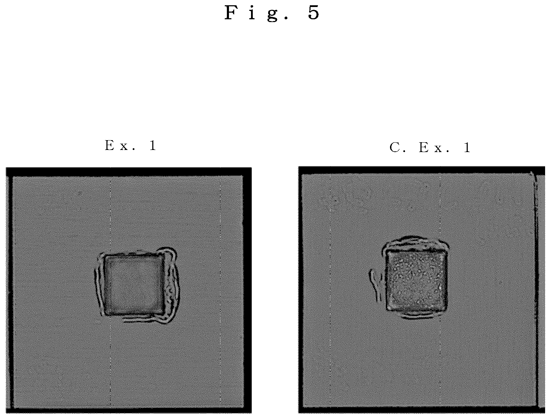

Fig. 5 shows examples of ultrasonic flaw detection images on the uniformity evaluation results of the close adhesion layers. In Fig. 5, the results of Example 1 and Comparative Example 1 are extracted. As can be seen from the above evaluation results, the close adhesion layer of the thermal bonding sheet of each of Examples includes the sinterable particles for which two hills are observed on the large particle side and the small particle side in the particle size distribution measurement, and thus had good dispersibility of the organic binder and good uniformity inside the layer. In contrast, the close adhesion layer of each of Comparative Examples includes the sinterable particles for which one hill is observed in the particle size distribution measurement, and thus did not necessarily have good dispersibility of the organic binder and had low uniformity inside the layer.

### <Peeling test of close adhesion layer from wafer (close adhesiveness evaluation of close adhesion layer)>

Each thermal bonding sheet including only the sinter precursor layer and the close adhesion layer was cut to obtain a test sample having a size of 10 mm × 100 mm. The test sample was attached to a Si wafer (150 mm in diameter, 550 µm thick) plated with Ti (0.1 µm thick) / Ag (0.75 µm thick), and was pressure-bonded to the Si wafer by reciprocating a 2 kg roller once while being heated on a hot plate at 70°C. Each thermal bonding sheet was pressure-bonded to the Si wafer to allow the Si wafer and the close adhesion layer to be in contact with each other. After the pressure-bonding, the thermal bonding sheet was left to stand at ordinary temperature for 30 minutes. The test sample was peeled off from the Si wafer in a 180° direction at a tensile rate of 300 mm/min using a Tensilon tester. The adhesive force during the peeling was measured. The results are shown in Table 1 and Table 2.

As can be understood from the results of the adhesiveness evaluation results, each of the close adhesion layers had good adhesiveness to the wafer when the proportion of the first silver particles and the second silver particles in the close adhesion layer falls within the specific range, and when the proportion of the second silver particles to the sum of the first silver particles and the second silver particles falls within the specific range.

### Industrial Applicability

The thermal bonding sheet of the present disclosure is suitably used as, for example, an auxiliary tool for producing a semiconductor device.

### REFERENCE SIGNS LIST

10: Thermal bonding sheet
1: Close adhesion layer
2: Sinter precursor layer
3: Component transferring prevention layer
100: Dicing tape-equipped thermal bonding sheet
20: Dicing tape
21: Substrate layer
22: Adhesive layer
A: Collet
X: Semiconductor chip
D: Ceramic insulating layer
E: Copper die pad
F: Copper thin layer
H: Stage

## Claims

1. A thermal bonding sheet comprising: a sinter precursor layer comprising sinterable particles; and a close adhesion layer superposed on one surface of the sinter precursor layer, wherein
the close adhesion layer comprises an organic binder and sinterable particles, and a content percentage of the sinterable particles in the close adhesion layer is 5 volume % or more and 40 volume % or less, and
a particle size distribution measured for the sinterable particles included in the close adhesion layer has at least two peaks.

2. The thermal bonding sheet according to claim 1, wherein a volume content percentage of the sinterable particles in the sinter precursor layer is higher than a volume content percentage of the sinterable particles in the close adhesion layer.

3. The thermal bonding sheet according to claim 1 or 2, wherein the sinter precursor layer comprises 30 volume % or more and 70 volume % or less of the sinterable particles.

4. The thermal bonding sheet according to any one of claims 1 to 3, wherein the close adhesion layer comprises 15 volume % or more and 35 volume % or less of the sinterable particles.

5. The thermal bonding sheet according to any one of claims 1 to 4, wherein
among a hill with a highest peak and a hill with a second highest peak in the particle size distribution, the hill on a large particle side represents a hill of a large particle group of the sinterable particles, and
a proportion of the sinterable particles in the large particle group to the sinterable particles included in the close adhesion layer is 5% or more and 30% or less based on volume %.

6. The thermal bonding sheet according to any one of claims 1 to 5, wherein both the sinter precursor layer and the close adhesion layer comprise a thermally decomposable binder as the organic binder.

7. The thermal bonding sheet according to any one of claims 1 to 6, wherein the sinter precursor layer has a thickness of 5 µm or more and 100 µm or less, and the close adhesion layer has a thickness of 2 µm or more and 20 µm or less.

8. A dicing tape-equipped thermal bonding sheet comprising: the thermal bonding sheet according to any one of claims 1 to 7; and a dicing tape superposed on one surface of the thermal bonding sheet, wherein
the sinter precursor layer of the thermal bonding sheet is disposed between the close adhesion layer and the dicing tape.

9. The dicing tape-equipped thermal bonding sheet according to claim 8, further comprising a component transferring prevention layer, wherein
the component transferring prevention layer is disposed between the sinter precursor layer and the dicing tape.
